# EUROPEAN PATENT SPECIFICATION

(11) **EP 0 457 285 B1**
(45) Date of publication and mention of the grant of the patent: **28.10.1998**
(21) Application number: 91107809.5
(22) Date of filing: 14.05.1991
(51) Int. Cl.: G01R 33/38, H01F 6/00, H01F 6/06

(54) **Apparatus for generating static magnetic field used by MRI system and method for assembling said apparatus**
Apparat zur Erzeugung des statischen Magnetfeldes für ein System zur Bilderzeugung mit magnetischer Kernresonanz und Methode für die Montage des Apparates
Appareil pour la génération du champ magnétique statique d'un système à IRM et méthode pour l'assemblage du dit appareil

(30) Priority: 15.05.1990 JP 123053/90
(43) Date of publication of application: 21.11.1991
(73) Proprietor: KABUSHIKI KAISHA TOSHIBA, Kawasaki-shi, Kanagawa-ken 210 (JP)
(72) Inventor: Sasaki, Katsutoki, c/o Intell. Prop. Division, Minato-ku, Tokyo 105 (JP)
(74) Representative: Henkel, Feiler, Hänzel

(56) References cited:
- EP-A- 141 149
- EP-A- 243 669
- WO-A-89/01636
- DE-A- 3 819 542
- GB-A- 2 197 487
- US-A- 5 001 448

## Description

The present invention relates to an apparatus for generating a static magnetic field used by an MRI (Magnetic Resonance Imaging) system that obtains at least one of anatomical data and organic data of a living body by utilizing a magnetic resonance phenomenon, and a method for assembling the apparatus.

An MRI system uses a static magnetic field generating apparatus capable of generating a high-strength, high-uniformity static magnetic field in order to obtain high-precision vital data. Accordingly, a static field generating apparatus has a magnet for generating a high-strength magnetic field of several thousands gauss or more. However, a magnet that generates such a high-strength magnetic field has electromagnetic adverse effects on other electronic appliances arranged close to it. In order to decrease this adverse effect, the static magnetic field generating apparatus has a magnetic shield body for decreasing a leakage magnetic field generated by the magnet. The magnetic shield body reduces the space required for installing an MRI system. This moderates the installation condition for the MRI system.

Document EP-A-0 243 669 discloses a (NMR) tomographic apparatus comprising a magnet system with magnetic coils which are supported by a frame structure through supporting elements. The magnet system is surrounded by shielding elements. At the frame structure adjusting means are provided for adjusting the respective magnetic coils.

Document WO-A-89/01636 describes a unitary superconducting electromagnet having an outer ferromagnetic body about an inner generally cylindrical body containing the coils and used for a nuclear magnetic resonance tomography apparatus. The electromagnet has adjusting blocks secured to the cylindrical inner body for movement of this body vertically and longitudinally in the outer body for precise positioning.

Document EP-A-0 141 149 discloses a magnetic apparatus wherein four bar-like shielding elements surround the surface of several cylindrical coils. In the apparatus the magnetic coils can be adjusted.

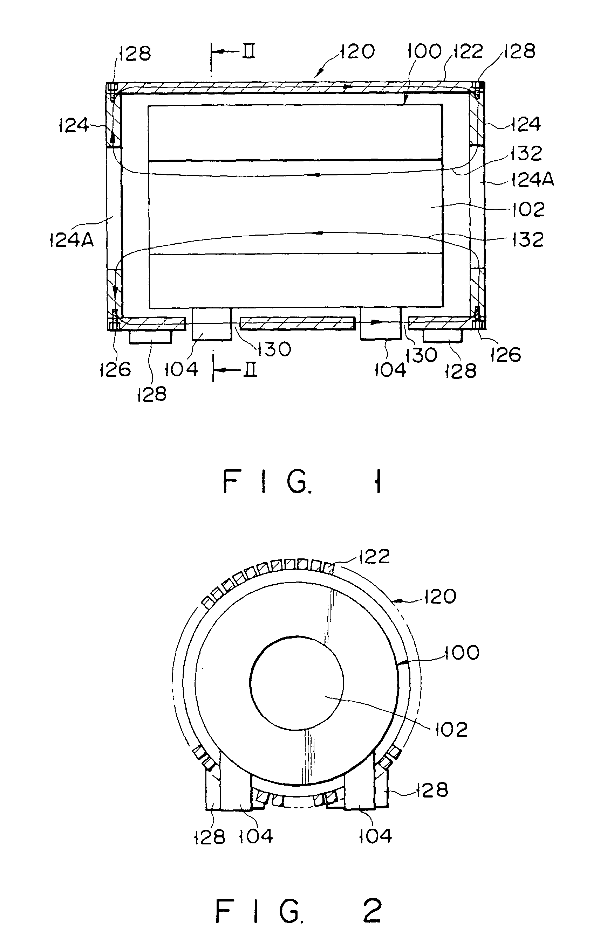

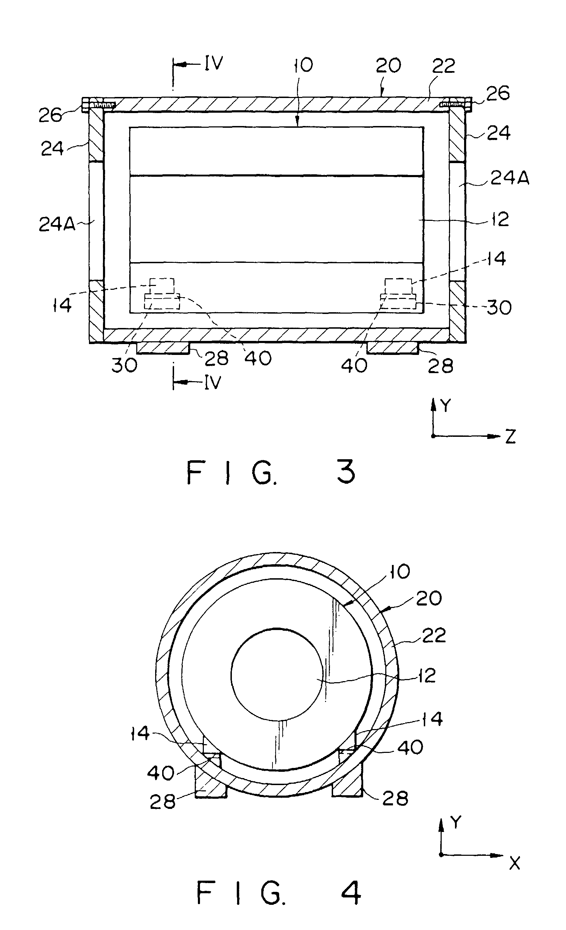

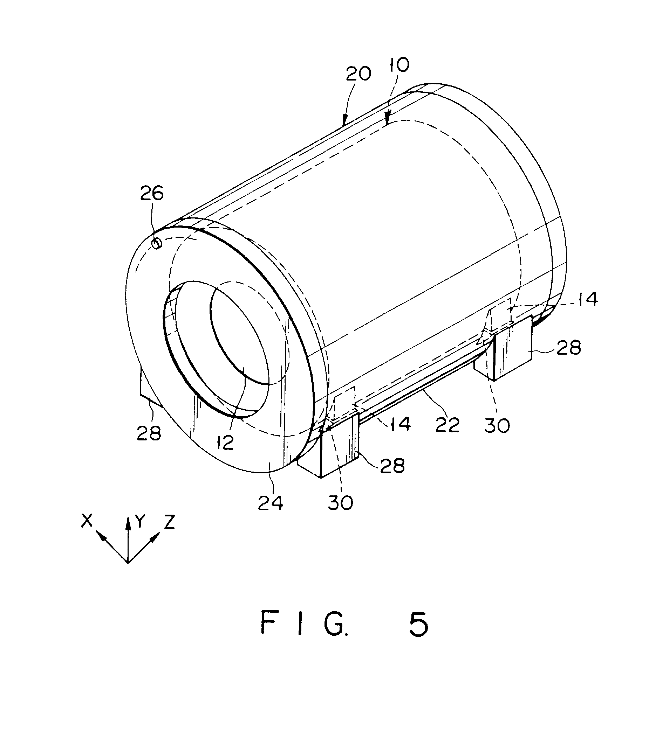

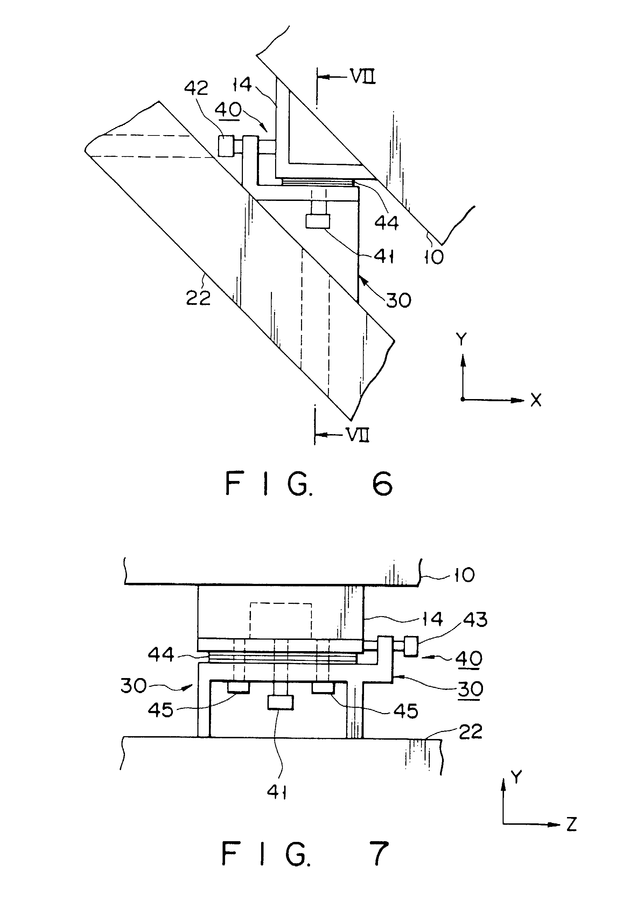

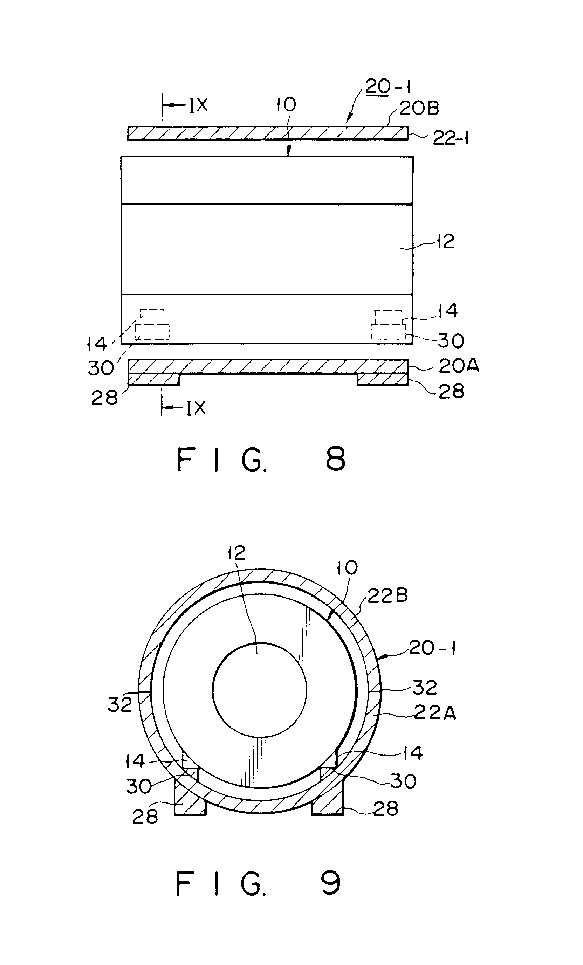

A conventional static magnetic field generating apparatus having a magnet and a magnetic shield body will be described with reference to Figs. 1 and 2.

As shown in Figs. 1 and 2, a static magnetic field generating apparatus is constituted by a magnet 100, e.g., a superconducting magnet, and a magnetic shield body 120 enclosing the magnet 100. The magnet 100 is cylindrical. An object to be examined (not shown) is placed in a hollow portion 102 inside the magnet 100. Magnet legs 104 for supporting the magnet 100 are fixed at four lower corners of the magnet 100. The magnetic shield body 120 consists of a plurality of square rods 122, two terminal lids 124 each having a central opening 124A, and a plurality of bolts 126 for fixing the square rods 122 to the terminal lids 124. The plurality of square rods 122, the two terminal lids 124, and the plurality of bolts 126 are made of a magnetic material. The plurality of square rods 122 are arranged on the outer circumferential surfaces of the terminal lids 124. The square rods 122 are fixed on the terminal lids 124 by the bolts 126. Shield legs 128 are fixed on the four lower corners of the magnetic shield body 120. The magnet legs 104 supporting the magnet 100 penetrate the square rods 122 constituting the magnetic shield body 120. Thus, four magnet leg accesses 130 are formed in advance in the magnetic shield body 120.

In the static magnetic field generating apparatus having this arrangement, of the magnetic fluxes generated by the magnet 100, those passing through the magnetic shield body 120 are indicated by lines 132. Since the magnet 100 is enclosed in the magnetic shield body 120, the leakage magnetic flux amount of the magnetic field generated by the magnet 100 can be decreased.

In the static magnetic field generating apparatus having this arrangement, the magnet legs 104 supporting the magnet 100 penetrate the square rods 122 constituting the magnetic shield body 120. Therefore, the four magnet leg accesses 130 are formed in advance in the magnetic shield body 120. Accordingly, the square rods 122 are not present where the magnet leg accesses 130 are present.

However, the square rods 122 are the magnetic flux paths (magnetic paths). Therefore, the partial absence of the square rods 122 interferes with flow of the magnetic fluxes within the magnetic shield body 120. As a result, the static magnetic field distribution of the hollow portion 102 of the magnet 100 is disturbed, thus degrading the uniformity in static magnetic field. High-precision vital data cannot be obtained due to this. In addition, the leakage magnetic flux amount is increased, and the shield effect is degraded. This imposes a strict condition for installation of the MRI system.

Document GB-A-2 197 487 discloses a magnetic shield for a magnetic resonance magnet adapted to surround the magnetic resonance magnet. The shield comprises two units which are so constructed that they can be assembled to surround the magnet by moving them horizontally. The magnetic shield body has a plurality of legs attached to the underside of the outer surface thereof and a plurality of support members for supporting a cylindrical superconducting magnet. The shield body has two axial openings, two terminal lids with a central opening, which are butted against the two axial openings, and a plurality of bolts for fixing the terminal lids to the cylindrical shell. In a further embodiment, a magnetic shield body is shown which is split into two halves along a direction parallel to a longitudinal direction of the cylindrical magnet.
The static magnet of this apparatus is fixed on the outer wall of the cylindrical magnetic shield, and thus the magnetic shield is provided with cut-away portions or openings into which the supporting legs of the static magnet are inserted. The size of the cut-away portions or openings, however, may effect the precision of the uniform magnetic field and the image processing.

It is, therefore, an object of the present invention to provide an apparatus for generating a static magnetic field, which is used in an MRI system capable of obtaining high-precision vital data and which can moderate an installation condition for the MRI system, and a method for assembling the apparatus.

This object is achieved with an apparatus for generating a static magnetic field used by a magnetic resonance imaging system, comprising a cylindrical superconducting magnet for generating a static magnetic field, a magnetic shield body for shielding magnetism generated by the cylindrical superconducting magnet, the magnetic shield body having a plurality of legs attached at predetermined positions to the underside of the outer surface thereof and being coaxially arranged outside of the cylindrical superconducting magnet, and a plurality of support members for supporting the cylindrical superconducting magnet, wherein said support members are fixed to the inner surface of said magnetic shield body at positions corresponding to the positions of said plurality of legs, said support members each have a mechanism for performing position adjustment of said magnetic shield body and said cylindrical superconducting magnet in x-, y- and z-axis directions, and said magnet shield body includes a cylindrical shell having two axial openings which comprises first and second split bodies split into halves along a direction parallel to a longitudinal direction of said cylindrical magnet, two terminal lids each having a central opening which are butted against the two axial openings of the cylindrical shell, and a plurality of bolts for fixing the terminal lids to the cylindrical shell.

This object is also achieved with a method for assembling an apparatus for generating a static magnetic field used by a magnetic resonance imaging system, said apparatus comprising a cylindrical magnet for generating a static magnetic field in a predetermined magnetic field generation direction, a magnetic shield body for shielding magnetism generated by said cylindrical magnet, said magnetic shield body having a plurality of legs at lower portions of an outer surface thereof, and being coaxially arranged outside of said cylindrical magnet, said magnetic shield body includes a cylindrical shell having two axial openings which comprises first and second split bodies split into halves along a direction parallel to a longitudinal direction of said cylindrical magnet, two terminal lids each having a central opening which are butted against the two axial openings of the cylindrical shell, and a plurality of bolts for fixing the terminal lids to the cylindrical shell, and a plurality of support members being fixed to the inner surface of said magnetic shield body at positions corresponding to the positions of said plurality of legs, for supporting said cylindrical magnet, said support members being fixed to those lower portions of an inner surface of said magnetic shield body which correspond to positions of said plurality of legs, and each having a mechanism for performing position adjustment of said magnetic shield body and said cylindrical magnet in x-, y-, and z-axis direction, said method comprising a first step of installing said first split body of said magnetic shield body on a floor, a second step of supporting said cylindrical magnet by said plurality of support members while suspending and moving said cylindrical magnet downward into the interior of said first split body, a third step of placing said second split body of said magnetic shield body on said first split body, a fourth step of butting against the two axial openings of the cylindrical shell by said two terminal lids, and a fifth step of fixing the terminal lids to the cylindrical shell by the plurality of bolts thereby integrally forming said magnetic shield body.

Since the magnetic shield body of this static magnetic field generating apparatus has no magnet leg accesses, the magnetic shield effect and the magnetic field uniformity are improved. In addition, since the magnetic shield body is split into at least halves in a direction perpendicular to the magnetic field generating direction, assembly of the apparatus is easy.

This invention can be more fully understood from the following detailed description when taken in conjunction with the accompanying drawings, in which:
Fig. 1 is an axial-direction sectional view of an example of a conventional static magnetic field generating apparatus having a magnet and a magnetic shield body;
Fig. 2 is a sectional view taken along the line II - II of Fig. 1;
Fig. 3 is an axial-direction sectional view of a static magnetic field generating apparatus according to the first embodiment not claimed by the present invention, which has a magnet and a magnetic shield body;
Fig. 4 is a sectional view taken along the line IV - IV of Fig. 3;
Fig. 5 is a perspective view of the static magnetic field generating apparatus shown in Figs. 3 and 4 according to the first embodiment;
Fig. 6 is a partially sectional view of a position adjusting mechanism;
Fig. 7 is a sectional view taken along the line VII - VII of Fig. 6;
Fig. 8 is an axial-direction sectional view of a static magnetic field generating apparatus according to the second embodiment not claimed by the present invention, which has a magnet and a split type magnetic shield body;
Fig. 9 is a sectional view taken along the line IX - IX of Fig. 9;
Fig. 10 is a perspective view of the static magnetic field generating apparatus shown in Figs. 8 and 9 according to the second embodiment;
Fig. 11 is a sectional view of a static magnetic field generating apparatus according to the third embodiment not claimed by the present invention and is similar to that taken along the line IX - IX of Fig. 8;
Fig. 12 is a perspective view of a static magnetic field generating apparatus according to the fourth embodiment of the present invention, which has terminal lids;
Fig. 13 is a perspective view of a static magnetic field generating apparatus according to the fifth embodiment of the present invention, which has terminal lids and flanges;
Fig. 14 is a perspective view of a static magnetic field generating apparatus according to the sixth embodiment of the present invention, which has terminal lids and access ports; and
Fig. 15 is a disassembled perspective view showing a method of assembling the static magnetic field generating apparatus shown in Fig. 12.

The preferred embodiments of the present invention will be described with reference to the accompanying drawings.

As shown in Figs. 3, 4, and 5, a static magnetic field generating apparatus according to the first embodiment (not claimed by the present invention) comprises a cylindrical superconducting magnet 10 and a magnetic shield body 20 enclosing the superconducting magnet 10. More specifically, the superconducting magnet 10 is arranged substantially coaxially in the magnetic shield body 20. The magnetic shield body 20 decreases the leakage magnetic flux amount of the magnetic field generated by the superconducting magnet 10.

A superconducting coil, a coolant such as liquid helium, and a heat insulator are sealed in the cylindrical superconducting magnet 10. A high-strength, high-uniformity static magnetic field can be generated in a hollow portion 12 in the superconducting magnet 10. An object to be examined (not shown) can be placed in the hollow portion 12 of the superconducting magnet 10. Therefore, a high-strength, high-uniformity static magnetic field can be applied to the object (not shown). In addition to the static magnetic field, a gradient magnetic field and an RF magnetic field are required in order to acquire a magnetic resonance signal from a specific portion of the object. A coil for generating the gradient magnetic field and a coil for generating the RF magnetic field can be arranged in the hollow portion 12 in the cylindrical superconducting magnet 10. These coils are not shown in the drawings. The coil for acquiring the magnetic resonance signal also serves as the coil for generating the RF magnetic field. However, an independent coil for acquiring the magnetic resonance signal can be used instead. Magnet support members 14 for supporting the superconducting magnet 10 are fixed on the four lower corners of its outer circumferential surface.

The magnet shield body 20 consists of a cylindrical shell 22, two terminal lids 24 each having a central opening 24A, and a plurality of bolts 26 for fixing the terminal lids 24 to the cylindrical shell 22. The shell 22, the two terminal lids 24, and the plurality of bolts 26 are made of a magnetic material. The terminal lids 24 are butted against the two axial openings of the cylindrical shell 22. The two terminal lids 24 are fixed to the cylindrical shell 22 by the bolts 26. Shield body legs 28 are fixed on the four lower corners of the magnetic shield body 20. Support members 30 for receiving the support members 14 of the magnet 10 are fixed on the four lower corners of the inner circumferential surface of the magnetic shield body 20. Each support member 30 includes a position adjusting mechanism 40. Each position adjusting mechanism 40 can move in at least one of x-, y-, and z-axis directions. Thus, the cylindrical superconducting magnet 10 can be set at a desired position. The four magnet support members 14 are supported by the four support members 30 of the magnetic shield body 20.

The position adjusting mechanisms 40 will be described in detail with reference of Figs. 6 and 7. More specifically, each position adjusting mechanism 40 comprises bolts 41, 42, 43, and 45 screwed to the corresponding support member 30, and a spacer 44. The bolt 41 adjusts the position of the cylindrical superconducting magnet 10 in the vertical direction (y-axis direction). The bolts 42 and 43 adjust the position of the superconducting magnet 10 in the horizontal direction (x-axis direction). The spacer 44 is arranged between the support member 30 and the magnet support member 14. The bolts 45 serve to fix the support member 30 and the magnet support member 14. In the position adjusting mechanism 40 having this arrangement, when the bolt 45 is unscrewed and the bolts 41, 42, and 43 and the spacer 44 are adjusted, the positional relationship between the cylindrical superconducting magnet 10 and cylindrical shell 22 of the magnetic shield body 20 can be optimized.

In the static magnetic field generating apparatus having this arrangement, since the magnet support members 14 are arranged inside the magnetic shield body 20, the magnetic shield body 20 is free from a notch, a hole, or the like that interferes with the magnetic flux flow. As a result, the magnetic fluxes generated by the cylindrical superconducting magnet 10 flow in the magnetic shield body 20 in an ideal manner. Thus, the magnetic shield effect is improved and the magnetic field uniformity becomes good. When such static magnetic field generating apparatuses are manufactured in a mass production system, they will have uniform static magnetic field generating characteristics.

Since the magnetic shield body 20 employs the cylindrical shell 22, the shell 22 and the terminal lids 24 can be coupled to each other easily and reliably. In this case, only several bolts 26 are required to couple the cylindrical shell 22 and the terminal lids 24.

Since the cylindrical superconducting magnet 10 and the magnetic shield body 20 are integrally formed, they need not be disassembled for transportation. Also, they need not be reassembled for installation, resulting in easy installation. The structure becomes simple to decrease the manufacturing cost, the assembly cost, and the installation cost, resulting in an inexpensive apparatus.

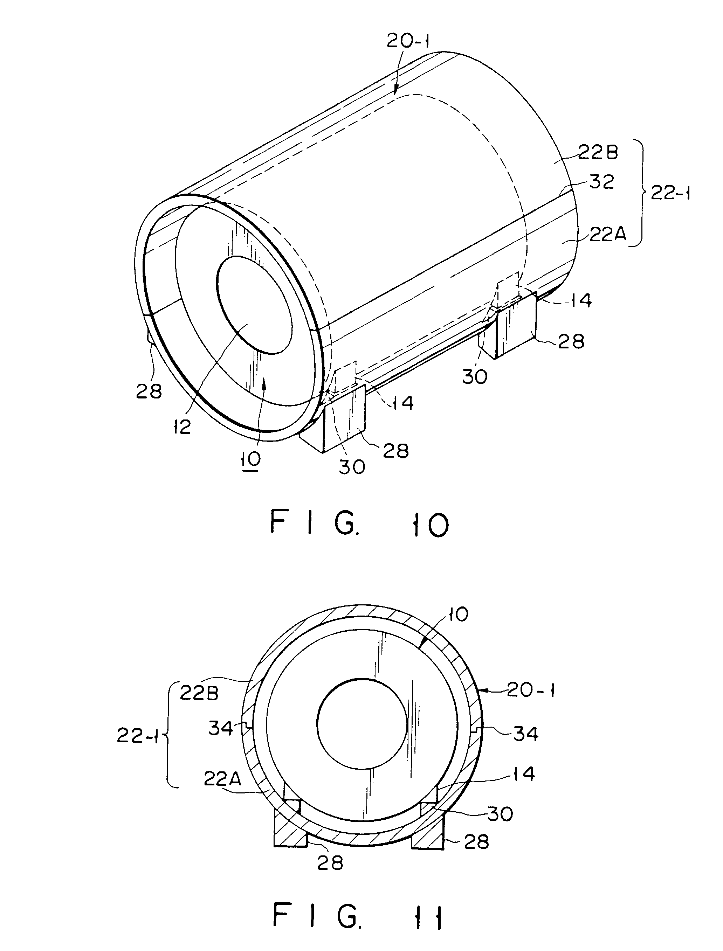

The second embodiment (not claimed by the present invention) will be described with reference to Figs. 8, 9, and 10. In a static magnetic field generating apparatus 20-1 according to the second embodiment, a cylindrical superconducting magnet 10 is substantially the same as that of the first embodiment. No terminal lids are provided, and a magnetic shield body comprising a split type cylindrical shell 22-1 split into halves is employed. Since the split type cylindrical shell 22-1 does not have terminal lids, the cylindrical superconducting magnet 10 preferably has an auto shield function. The cylindrical superconducting magnet 10 having the auto shield function has a coil assembly in which a cancel coil is provided outside a main coil. The split type cylindrical shell 22-1 consists of lower and upper split bodies 22A and 22B. The lower and upper split bodies 22A and 22B are coupled through split lines 32. The split lines 32 are of a surface coupling type.

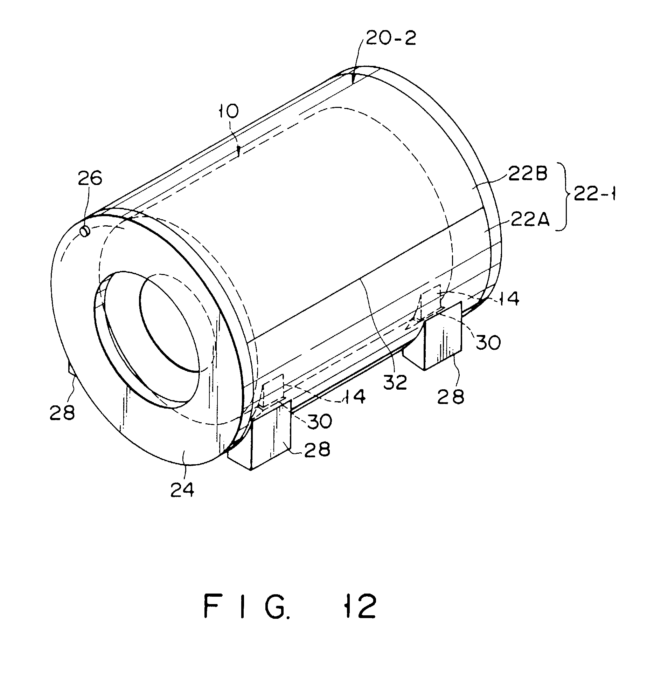

The third embodiment (not claimed by the present invention) will be described with reference to Fig. 11. A static magnetic field generating apparatus 20-1 according to the third embodiment does not have terminal lids and adopts a magnetic shield body comprising a split type cylindrical body 22-1 split into halves, as in the second embodiment. Lower and upper split bodies 22A and 22B are coupled through split lines 34. The split lines 34 are of a step coupling type.

The fourth embodiment of the present invention will be described with reference to Fig. 12. A static magnetic field generating apparatus 20-2 according to the fourth embodiment employs a magnetic shield body 22-2 obtained by providing terminal lids 24 to a split type cylindrical shell 22-1, unlike in the second and third embodiments.

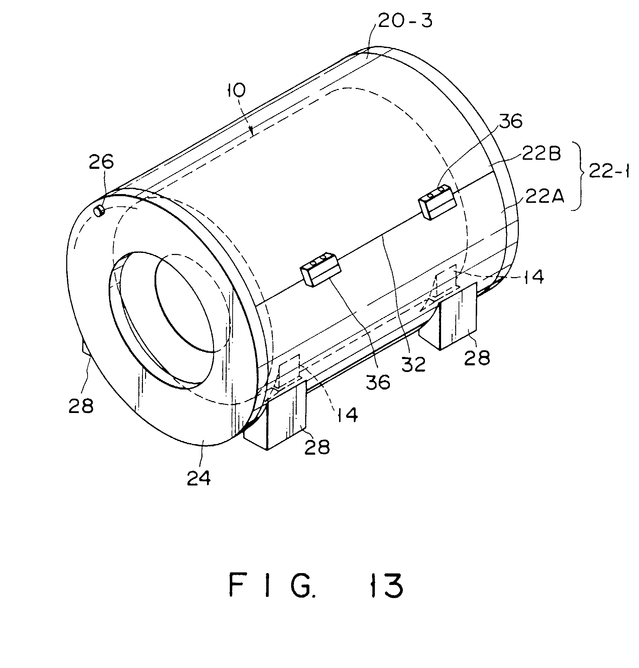

The fifth embodiment of the present invention will be described with reference to Fig. 13. A static magnetic field generating apparatus 20-3 of the fifth embodiment is substantially the same as that of the fourth embodiment except that in the fifth embodiment flange mechanisms 36 are provided to split lines 32 for fixing and coupling lower and upper split bodies 22A and 22B.

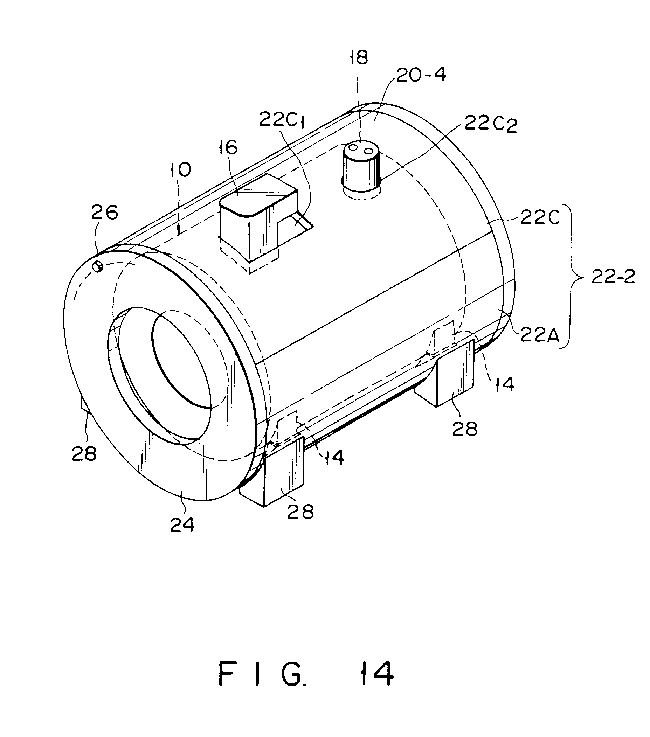

The sixth embodiment of the present invention will be described with reference to Fig. 14. A static magnetic field generating apparatus 20-4 of the sixth embodiment is substantially the same as that of the fourth embodiment except for the following respects. Namely, in the sixth embodiment, a notch 22cl for a coolant supply port 16 and a notch 22c2 for a charging port 18 are formed in an upper split body 22C so as to allow mounting of the coolant supply port 16 and the charging port 18.

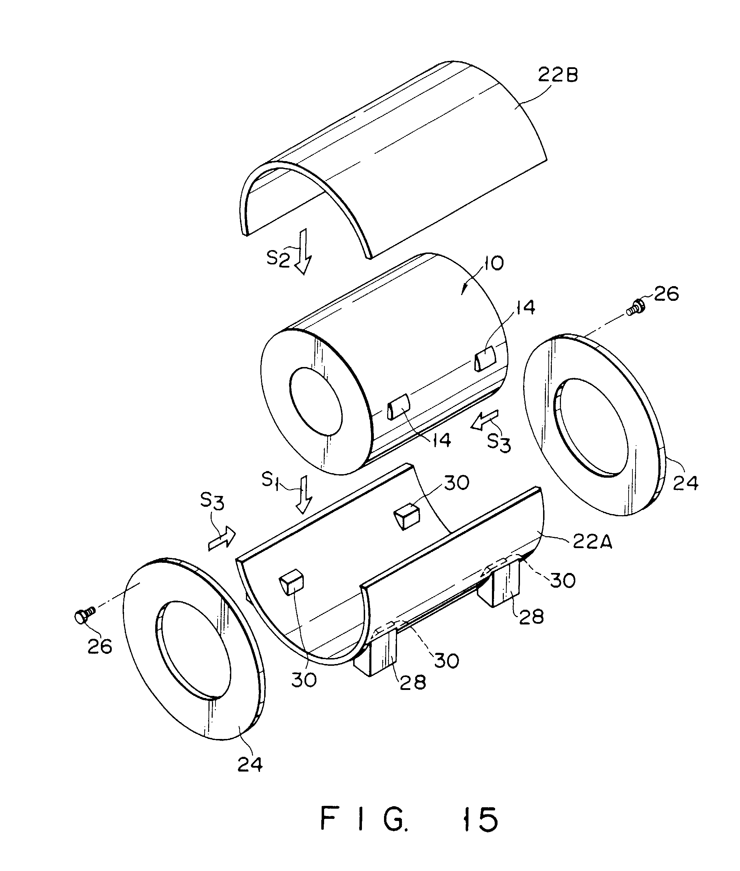

A method for assembling the static magnetic field generating apparatus according to the present invention will be described with reference to Fig. 15. As an example, a method for assembling the static magnetic field generating apparatus shown in Fig. 12 will be described. More specifically, in the preparatory step, the lower magnetic shield body 22A is installed on a floor (not shown). Subsequently, in step S1, the magnet 10 is suspended and is moved downward to the interior of the lower split body 22A such that the support members 14 of the magnet 10 are received by the support members 30 of the lower split body 22A. In step S2, the upper split body 22B is placed on the lower split body 22A. Thus, the cylindrical shell 22-1 is completed. Then, in step S3, the terminal lids 24 are butted against the openings of the cylindrical shell 22-1 and screwed to it by the bolts 26.

In this manner, since the cylindrical shell 22-1 is split into upper and lower halves, its upper split body 22B can be fixed and assembled after suspending and moving the magnet 10. As a result, assembly becomes easy. In addition, since the split lines 32 are parallel to the flowing direction of the magnetic fluxes, even if the contacting state of the upper and lower split bodies 22B and 22A is not very good, it will not influence the magnetic field uniformity.

In any of the embodiments described above, the magnet 10 is a superconducting magnet. However, it can be a normal conductive magnet.

As has been described above, according to the present invention, the support members 30 are provided on the inner circumferential surface of the cylindrical shell 22 and the magnet 10 is received by and fixed on the support members 30. As a result, the number of notches or holes in the magnetic shield body 20 is decreased, resulting in an improvement in magnetic field uniformity and decrease in leakage magnetic field. Since the magnet 10 and the magnetic shield body 20 are integrally formed, disassembly and assembly for installation can be easily performed.

Since the terminal lids and the cylindrical shell can be coupled easily and reliably, a variation in magnetic field uniformity due to assembly is decreased, thus providing an inexpensive magnetic shield body having a stable quality.

## Claims

1. An apparatus for generating a static magnetic field used by a magnetic resonance imaging system, comprising:
a cylindrical superconducting magnet (10) for generating a static magnetic field;
a magnetic shield body (20, 20-1, 20-2, 20-3, 204) for shielding magnetism generated by said cylindrical superconducting magnet (10), said magnetic shield body (20, 22A, 22B, 24, 24A, 26) having a plurality of legs (28) attached at predetermined positions to the underside of the outer surface thereof and being coaxially arranged outside of said cylindrical superconducting magnet (10); and
a plurality of support members (30) for supporting said cylindrical superconducting magnet (10),
characterized in that
said support members (30) are fixed to the inner surface of said magnetic shield body (20, 22A, 22B, 24, 24A, 26) at positions corresponding to the positions of said plurality of legs (28),
said support members (30) each have a mechanism (40) for performing position adjustment of said magnetic shield body (20, 22A, 22B, 24, 24A, 26) and said cylindrical superconducting magnet (10) in x-, y- and z-axis directions, and
said magnet shield body (20, 22A, 22B, 24, 24A, 26) includes a cylindrical shell (22) having two axial openings which comprises first and second split bodies (22A, 22B) split into halves along a direction parallel to a longitudinal direction of said cylindrical magnet (10), two terminal lids (24) each having a central opening (24A) which are butted against the two axial openings of the cylindrical shell (22), and a plurality of bolts (26) for fixing the terminal lids (24) to the cylindrical shell (22).

2. An apparatus used by a magnetic resonance imaging system according to claim 1, wherein said magnetic shield body (20, 22A, 22B, 24, 24A, 26) has a notch (20C₁, 20C₂) in an upper portion thereof for allowing a member (16, 18) for cooling and charging to extend therethrough, said member (16, 18) for cooling and charging being installed on said cylindrical magnet (10).

3. A method for assembling an apparatus for generating a static magnetic field used by a magnetic resonance imaging system, said apparatus comprising:
a cylindrical magnet (10) for generating a static magnetic field in a predetermined magnetic field generation direction;
a magnetic shield body (20, 22A, 22B, 24, 24A, 26) for shielding magnetism generated by said cylindrical magnet (10), said magnetic shield body (20, 22A, 22B, 24, 24A, 26) having a plurality of legs (28) at lower portions of an outer surface thereof, and being coaxially arranged outside of said cylindrical magnet (10), said magnetic shield body (20, 22A, 22B, 24, 24A, 26) includes a cylindrical shell (22) having two axial openings which comprises first and second split bodies (22A, 22B) split into halves along a direction parallel to a longitudinal direction of said cylindrical magnet (10), two terminal lids (24) each having a central opening (24A) which are butted against the two axial openings of the cylindrical shell (22), and a plurality of bolts (26) for fixing the terminal lids (24) to the cylindrical shell (22); and
a plurality of support members (30) being fixed to the inner surface of said magnetic shield body (20,22A,22B,24,24A,26) at positions corresponding to the positions of said plurality of legs (28), for supporting said cylindrical magnet (10), said support members (30) being fixed to those lower portions of an inner surface of said magnetic shield body (20, 22A, 22B, 24, 24A, 26) which correspond to positions of said plurality of legs (28), and each having a mechanism (40) for performing position adjustment of said magnetic shield body (20, 22A, 22B, 24, 24A, 26) and said cylindrical magnet (10) in x-, y-, and z-axis direction, said method comprising:
a first step of installing said first split body (20A) of said magnetic shield body (20, 22A, 22B, 24, 24A, 26) on a floor;
a second step of supporting said cylindrical magnet (10) by said plurality of support members (30) while suspending and moving said cylindrical magnet (10) downward into the interior of said first split body (22A);
a third step of placing said second split body (22B) of said magnetic shield body (20, 22A, 22B, 24, 24A, 26) on said first split body (22A) ;
a fourth step of butting against the two axial openings of the cylindrical shell (22) by said two terminal lids (24); and
a fifth step of fixing the terminal lids (24) to the cylindrical shell (22) by the plurality of bolts (26) thereby integrally forming said magnetic shield body (20, 22A, 22B, 24, 24A, 26).

## Patentansprüche

1. Apparat zur Erzeugung eines statischen Magnetfelds, der von einem System zur Bilderzeugung mit magnetischer Resonanz genutzt wird, und der umfaßt:
einen zylindrischen supraleitenden Magneten (10) zum Erzeugen eines statischen Magnetfelds;
einen magnetischen Abschirmkörper (20, 20-1, 20-2, 20-3, 20-4) zur Abschirmung des von dem zylindrischen supraleitenden Magneten (10) erzeugten Magnetfeldes, wobei der magnetische Abschirmkörper (20, 22A, 22B, 24, 24A, 26) eine Mehrzahl von Füßen (28) hat, die an vorbestimmten Positionen an der Unterseite seiner Außenfläche angebracht sind, und koaxial um den zylindrischen supraleitenden Magneten (10) angeordnet ist; und eine Mehrzahl von Tragelementen (30) für die Auflagerung des zylindrischen supraleitenden Magneten (10), dadurch gekennzeichnet, daß
die Tragelemente (30) an der Innenseite des magnetischen Abschirmkörpers (20, 22A, 22B, 24, 24A, 26) an Positionen entsprechend den Positionen der Mehrzahl von Füßen (28) befestigt sind, wobei
jedes der Tragelemente (30) einen Mechanismus (40) für die Lagejustierung des magnetischen Abschirmkörpers (20, 22A, 22B, 24, 24A, 26) und des zylindrischen supraleitenden Magneten (10) in Richtung der x-, y- und z-Achse hat, und
der magnetische Abschirmkörper (20, 22A, 22B, 24, 24A, 26) einen zylindrischen Mantel (22) hat, der zwei axiale Öffnungen hat und erste und zweite geteilte Körper (22A, 22B) aufweist, die entlang einer Richtung parallel zu einer Längsrichtung des zylindrischen Magneten (10) in Hälften geteilt sind, zwei Abschlußdeckel (24), von denen jeder eine zentrale Öffnung (24A) hat, und die auf die beiden axialen Öffnungen des zylindrischen Mantels (22) aufgesetzt sind, und eine Vielzahl von Schrauben (26) zur Befestigung der Abschlußdeckel (24) an dem zylindrischen Mantel (22).

2. Apparat nach Anspruch 1, der von einem System zur Bilderzeugung mit magnetischer Resonanz genutzt wird, bei dem der magnetische Abschirmkörper (20, 22A, 22B, 24, 24A, 26) eine Aussparung (22C₁, 22C₂) in seinem oberen Abschnitt hat, durch die ein Element (16, 18) für Kühlen und Laden eingeführt werden kann, wobei das Element (16, 18) für Kühlen und Laden an dem zylindrischen Magneten (10) angebracht wird.

3. Verfahren für die Montage eines Apparats zur Erzeugung eines statischen Magnetfelds, der von einem System zur Bilderzeugung mit magnetischer Resonanz genutzt wird, wobei der Apparat umfaßt:
einen zylindrischen Magneten (10) für die Erzeugung eines statischen Magnetfelds in einer vorbestimmten Erzeugungsrichtung für das Magnetfeld;
einen magnetischen Abschirmkörper (20, 22A, 22B, 24, 24A, 26) für die Abschirmung des von dem zylindrischen Magneten (10) erzeugten Magnetfelds, wobei der magnetische Abschirmkörper (20, 22A, 22B, 24, 24A, 26) eine Mehrzahl von Füßen (28) an unteren Abschnitten seiner Außenseite hat, und koaxial um den zylindrischen Magneten (10) angeordnet ist, der magnetische Abschirmkörper (20, 22A, 22B, 24, 24A, 26) einen zylindrischen Mantel (22) umfaßt, der zwei axiale Öffnungen hat und erste und zweite geteilte Körper (22A, 22B) aufweist, die entlang einer Richtung parallel zu einer Längsrichtung des zylindrischen Magneten (10) in hälften geteilt sind, zwei Abschlußdeckel (24), von denen jeder eine zentrale Öffnung (24A) hat, und die auf die beiden axialen Öffnungen des zylindrischen Mantels (22) aufgesetzt sind, und eine Vielzahl von Schrauben (26) zur Befestigung der Abschlußdeckel (24) an dem zylindrischen Mantel (22); und
eine Mehrzahl von Tragelementen (30), die an der Innenseite des magnetischen Abschirmkörpers (20, 22A, 22B, 24, 24A, 26) an Positionen entsprechend den Positionen der Mehrzahl von Füßen (28) befestigt sind, um den zylindrischen Magneten (10) aufzulagern, und von denen jedes einen Mechanismus (40) für die Lagejustierung des magnetischen Abschirmkörpers (20, 22A, 22B, 24, 24A, 26) und des zylindrischen Magneten (10) in Richtung der x-, y- und z-Achse hat, wobei die Methode umfaßt:
einen ersten Schritt für das Installieren des ersten geteilten Körpers (20A) des magnetischen Abschirmkörpers (20, 22A, 22B, 24, 24A, 26) auf einer Stellfläche; einen zweiten Schritt für das Auflagern des zylindrischen Magneten (10) auf die Mehrzahl von Tragelementen (30), wobei der zylindrische Magnet (10) aufgehängt ist und nach unten in den Innenraum des ersten geteilten Körpers (22A) abgesenkt wird;
einen dritten Schritt für das Aufsetzen des zweiten geteilten Körpers (22B) des magnetischen Abschirmkörpers (20, 22A, 22B, 24, 24A, 26) auf den ersten geteilten Körper (22A) ;
einen vierten Schritt für das Anbringen der beiden Abschlußdeckel (24) an den beiden axialen Öffnungen des zylindrischen Mantels (22); und
einen fünften Schritt für das Befestigen der Abschlußdeckel (24) mittels einer Vielzahl von Schrauben (26) an dem zylindrischen Mantel (22), womit der magnetische Abschirmkörper (20, 22A, 22B, 24, 24A, 26) komplett montiert ist.

## Revendications

1. Appareil pour créer un champ magnétique statique pour un système d'imagerie à résonance magnétique, comprenant :
un aimant (10) supraconducteur cylindrique pour créer un champ magnétique statique ;
un corps formant écran magnétique (20, 20-1, 20-2, 20-3, 20-4) pour faire écran au magnétisme créé par ledit aimant (10) supraconducteur cylindrique, ledit corps formant écran magnétique (20, 22A, 22B, 24, 24A, 26) ayant plusieurs pieds (28) fixés à des emplacements prédéterminés à la face de dessous de sa surface extérieure en disposition coaxiale à l'extérieur dudit aimant (10) supraconducteur cylindrique ; et
des éléments supports (30) pour supporter ledit aimant (10) supraconducteur cylindrique,
caractérisé en ce que
lesdits éléments supports (30) sont fixés à la surface intérieure dudit corps formant écran magnétique (20, 22A, 22B, 24, 24A, 26) à des emplacements correspondant aux emplacements desdits pieds (28),
lesdits éléments supports (30) ont chacun un mécanisme (40) pour effectuer un réglage de position dudit corps formant écran magnétique (20, 22A, 22B, 24, 24A, 26) et dudit aimant (10) supraconducteur magnétique dans des directions d'axes x, y et z, et
ledit corps formant aimant magnétique (20, 22A, 22B, 24, 24A, 26) comprend une enveloppe cylindrique (22) ayant deux ouvertures axiales qui comprend des premier et deuxième corps fractionnés (22A, 22B) fractionnés en moitiés le long d'une direction parallèle à une direction longitudinale dudit aimant (10) cylindrique, deux couvercles (24) terminaux ayant chacun une ouverture centrale (24A) qui sont aboutés contre les deux ouvertures axiales de l'enveloppe cylindrique (22), et des vis (26) pour fixer les couvercles terminaux (24) à l'enveloppe cylindrique (22).

2. Appareil pour système d'imagerie à résonance magnétique selon la revendication 1, dans lequel ledit corps formant écran magnétique (20, 22A, 22B, 24, 24A, 26) a une encoche (20C₁-20C₂) dans une partie supérieure pour permettre à un élément (16, 18) de refroidissement et de chargement de s'y étendre, ledit élément (16, 18) de refroidissement et de chargement étant disposé sur ledit aimant (10) cylindrique.

3. Procédé pour assembler un appareil pour créer un champ magnétique statique pour un système d'imagerie à résonance magnétique, ledit appareil comprenant :
un aimant (10) cylindrique pour créer un champ magnétique statique dans une direction de création de champ magnétique prédéterminée ;
un corps formant écran magnétique (20, 22A, 22B, 24, 24A, 26) pour confirmer le magnétisme créé par ledit aimant (10) cylindrique, ledit corps formant écran magnétique (20, 22A, 22B, 24, 24A, 26) ayant des pieds (28) à des parties inférieures de sa surface extérieure, coaxialement à l'extérieur dudit aimant (10) cylindrique, ledit corps formant écran magnétique (20, 22A, 22B, 24, 24A, 26) comporte une enveloppe cylindrique (22) ayant deux ouvertures axiales comprenant des premier et deuxième corps fractionnés (22A, 22B) fractionnés en moitiés le long d'une direction parallèle à une direction longitudinale dudit aimant (10) cylindrique, deux couvercles (24) terminaux ayant chacun une ouverture centrale (24A) qui sont aboutés contre les deux ouvertures axiales de l'enveloppe cylindrique (22), et des vis (26) pour fixer les couvercles terminaux (24) à l'enveloppe cylindrique (22) ; et
des éléments supports (30) fixés à la surface intérieure dudit corps formant écran magnétique (20, 22A, 22B, 24, 24A, 26) a des emplacements correspondant aux emplacements desdits pieds (28), pour supporter ledit aimant (10) cylindrique, lesdits éléments supports (30) étant fixés aux parties inférieures d'une surface intérieure dudit corps formant écran magnétique (20, 22A, 22B, 24, 24A, 26) qui correspondent aux emplacements desdits pieds (28), et chacun ayant un mécanisme (40) pour effectuer un réglage de position dudit corps formant écran magnétique (20, 22A, 22B, 24, 24A, 26) et dudit aimant (10) cylindrique dans des directions d'axes x, y et z, ledit procédé comprenant :
une première étape d'installation dudit premier corps fractionné (20A) dudit corps formant écran magnétique (20 , 22A, 22B, 24, 24A, 26) sur un sol ;
une deuxième étape de supportage dudit aimant (10) cylindrique par lesdits éléments supports (30) en suspendant et déplaçant ledit aimant (10) cylindrique vers le bas à l'intérieur dudit premier corps fractionné (22A);
une troisième étape de placement dudit deuxième corps fractionné (22B) dudit corps formant écran magnétique (20, 22A, 22B, 24, 24A, 26) sur ledit premier corps fractionné (22A);
une quatrième étape d'aboutement contre les deux ouvertures axiales de l'enveloppe cylindrique (22) desdits deux couvercles (24) terminaux et ; une cinquième étape de fixation des couvercles (24) terminaux à l'enveloppe (22) cylindrique par des vis (26) pour former ainsi d'un bloc ledit corps formant écran magnétique (20, 22A, 22B, 24, 24A, 26).
